# EUROPEAN PATENT APPLICATION

(11) **EP 4 576 194 A2**
(43) Date of publication of application: **25.06.2025**
(21) Application number: 24216472.1
(22) Date of filing: 29.11.2024
(51) Int. Cl.: H01L 23/04

(54) **POWER MODULE WITH DETACHABLE FUNCTION**

(30) Priority: 21.12.2023 TW 112149942
(71) Applicant: Industrial Technology Research Institute, 310401 Hsinchu (TW)
(72) Inventor: LIU, Yu-Cheng, Taichung City (TW); HUANG, Yuan-Cheng, New Taipei City (TW); CHIOU, Shian-Chiau, Miaoli County (TW); LIN, Hsin-Han, Hsinchu County (TW); LIU, Chun-Kai, Hsinchu City (TW)
(74) Representative: Bandpay & Greuter

(57) **Abstract**

A power module with detachable function is provided. The power module includes a housing box part, a power component, a housing cover part, and a sensing component. The sensing component is configured to measure parameters of the power component and detachably installed on the housing cover part and the housing box part. When the housing cover part is mounted on the housing box part, the housing cover part and the housing box part can restrict the movement of the sensing component. Thus, a tight fit can be achieved.

## Description

### CROSS REFERENCE TO RELATED APPLICATIONS

This application claims the priority benefit of Taiwan Patent Application No. 112149942, filed Dec. 21, 2023.

### TECHNICAL FIELD

The application relates to a power module with a detachable function.

### BACKGROUND

In the inverter of an electric vehicle, a sensor is disposed outside the power module. Often, the reaction time of the sensor is too long, so problems may arise including short circuits and current overloads in the system. In particular, the aforementioned problem is about the protection of the short circuit or the current overloads when the power module is integrated with a current sensor designed to measure the value of the current and detect variations in the current.

### SUMMARY

According to an embodiment of the disclosure, the power module includes a housing box part, a power component, a housing cover part, and a sensing component. The power component is mounted on the housing box part. The housing cover part is installed on the housing box part and includes a cover combination structure. The sensing component is user to measure parameters of the power component and includes a component combination structure. The component combination structure is detachably combined with the cover combination structure, so that the sensing component is detachably installed on the housing cover part.

According to another embodiment of the disclosure, the power module includes a housing box part, a power component, a housing cover part, and a sensing component. The housing box part includes a box combination structure. The power component is mounted on the housing box part. The housing cover part is installed on the housing box part. The sensing component is used to measure parameters of the power component. When the housing cover part is installed on the housing box part, the sensing component is inserted into the box combination structure, so that the sensor is detachably installed on the housing box part.

In said another embodiment of the disclosure, the power module may optionally present any one or more of the following features:
- the power module further comprises a metal terminal, disposed on the housing box part and coupled to the power component, wherein the sensing component is coupled to the metal terminal in direct contact or indirect contact;
- the sensing component measures a value of a current of the metal terminal in indirect contact or measures a value of a voltage of the metal terminal in direct contact;
- the box combination structure is a fixing slot, and when the housing cover part is installed on the housing box part, the sensing component is inserted into the fixing slot, and the sensing component can merely leave the housing cover part along an inserting direction due to a restriction of a slot wall of the fixing slot;
- the box combination structure is a metal recess on the metal terminal, and when the housing cover part is installed on the housing box part, the sensing component is inserted into the box combination structure and the metal recess; and/or
- the metal terminal comprises a hollow hole, and when the housing cover part is installed on the housing box part, the sensing component passes through the hollow hole and is inserted into the box combination structure.

According to the power module with detachable function disclosed in the disclosure, a combination method with detachable function is provided. The sensing component can be detachably installed on the power module by tight fitting, locking, or attaching. The sensing component can be easily replaced when the sensing component is abnormal or another sensing component having different measure range, having different sensitiveness, or measuring the voltage is required to use. Moreover, for prevent the power module from the short circuit or the overload of the current, the sensing component can stop the power module from operating according to the detected value of the current and/or the voltage.

### BRIEF DESCRIPTION OF DRAWINGS

The disclosure can be more fully understood by reading the subsequent detailed description and examples with references made to the accompanying drawings, wherein:
Fig. 1 is a schematic diagram of the structure of the power module according to an embodiment of the disclosure;
Fig. 2 is an exploded-view diagram of the power module in Fig. 1;
Fig. 3 is a schematic diagram of the housing cover part and the sensing component according to an embodiment of the disclosure;
Fig. 4 is a partial top view of the power module according to an embodiment of the disclosure, wherein the housing cover part is omitted;
Fig. 5 is a cross-sectional view taken along the line A-A in Fig. 1;
Fig. 6 is a schematic diagram of a power module according to another embodiment of the disclosure;
Fig. 7A is a schematic diagram of a power module according to another embodiment of the disclosure;
Fig. 7B is a schematic diagram of a power module according to another embodiment of the disclosure;
Fig. 8A and Fig. 8B are schematic diagrams of the assembling steps of the power module according to an embodiment of the disclosure;
Fig. 9A is a schematic diagram of the housing cover part and the sensing component according to another embodiment of the disclosure;
Fig. 9B is a schematic diagram of the housing cover part and the sensing component according to another embodiment of the disclosure; and
Fig. 10 is a flow chart diagram of the operation steps of the power module according to an embodiment of the disclosure.

### DETAILED DESCRIPTION

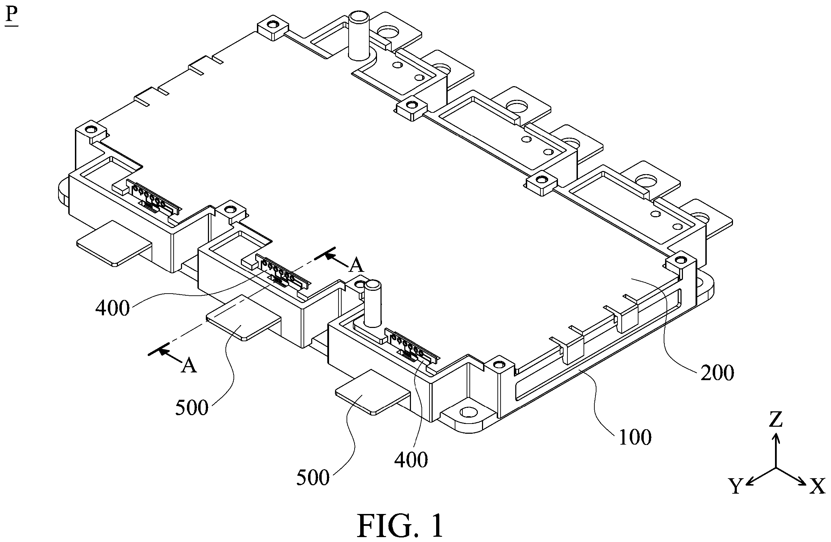

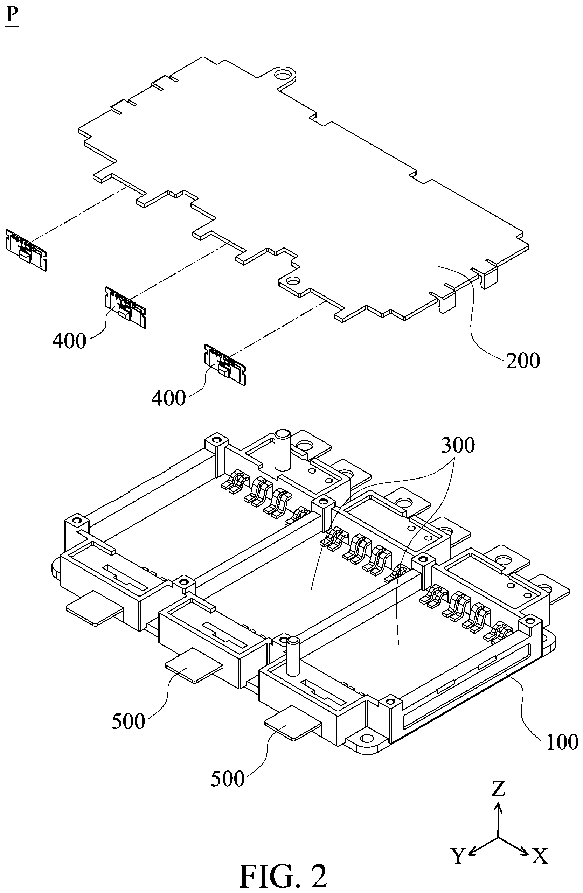

Fig. 1 is a schematic diagram of the structure of the power module P according to an embodiment of the disclosure, and Fig. 2 is an exploded-view diagram of the power module P in Fig. 1. As shown in Fig. 1 and Fig. 2, the power module P includes a housing box part 100, a housing cover part 200, a power component 300, and a sensing component 400. The housing cover part 200 is installed on the housing box part 100. The power component 300 is disposed in the housing box part 100. The sensing component 400 is used to measure the parameters of the power component 300. In detail, the power module P may include a metal terminal 500 disposed in the housing box part 100. The metal terminal 500 is coupled to the power component 300. More in particular, the sensing component 400 may be coupled to the metal terminal 500 in direct contact or indirect contact. In some embodiments, the power component 300 may be a switch, a resistor, an inductor, a capacitor, a diode, a power diode, an amplifier and/or a driver IC, or a combination thereof. Additionally, the switch may include Si MOSFET, SiC MOSFET, GaN MOSFET, and insulated gate bipolar transistor (IGBT), and the power diode may include Schottky barrier diode (SBD) and a fast recovery epitaxial diode (FRED), but it is not limited thereto. In some embodiments, the sensing component may be a hall effect sensor, a current clamp, a thermocouple sensor, an optical sensor, a resistor-based sensor, a MEMS (Micro-Electro-Mechanical Systems) coil sensor, an AMR (Anisotropic Magneto-Resistance) sensor, a GMR (Giant Magneto-Resistance) sensor, a TMR (Tunnel Magneto-Resistance) sensor, a fluxgate sensor and/or a current transducer, but it is not limited thereto. In some embodiments, the metal terminal 500 can include copper, aluminum, silver, copper alloy, or aluminum alloy, but it is not limited thereto.

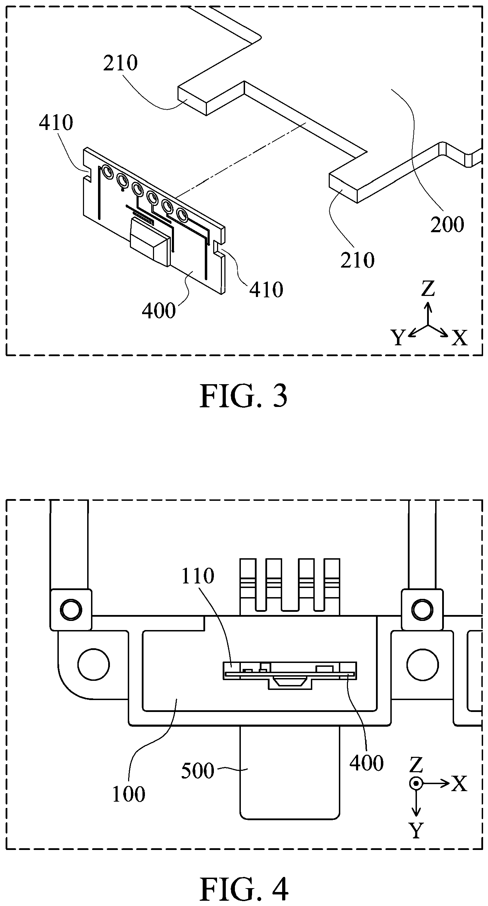

Fig. 3 is a schematic diagram of the housing cover part and the sensing component according to an embodiment of the disclosure. As shown in Fig. 3, the housing cover part 200 includes a cover combination structure 210, and the sensing component 400 includes a component combination structure 410. The component combination structure 410 is detachably engaged with the cover combination structure 210, so that the sensing component 400 is detachably installed on the housing cover part 200. In detail, the component combination structure 410 is detachably engaged with the cover combination structure 210, a resistance is provided between the component combination structure 410 and the cover combination structure 210, so that a tight fit can be achieved. The tight fit can restrict the movement of the sensing component 400 in a first axial direction and a second axial direction, wherein the first axial direction is perpendicular to the second axial direction. More in particular, the first axial direction is a first direction along the X-axis, and the second axial direction is a second direction along the Z-axis.

In some embodiments, the cover combination structure 210 is a positioning protrusion, and the component combination structure 410 is a positioning recess. In particular, the positioning protrusion may be tight fitted with the positioning recess. For example, the dimensions of the positioning protrusion can be greater than the dimensions of the positioning recess, or can be internal shirked relative to the positioning recess, so that the sensing component 400 can be tight fitted on the housing cover part 200, but it is not limited thereto. The cover combination structure 210 and the component combination structure 410 can be one or more groups/pairs of the mechanism to let the cover combination structure 210 and the component combination structure 410 detachably latching, buckling, and/or combing with each other and to achieve a tight fit. The sensing component 400 can be tight fitted on the housing cover part 200, and the sensing component 400 can be detached from the housing cover part 200 or combined to the housing cover part 200 again in any time.

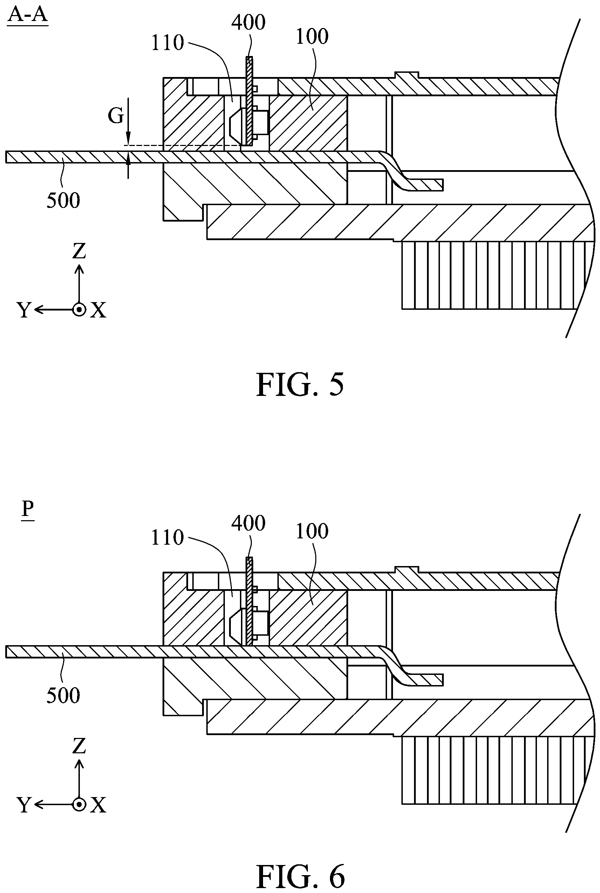

Fig. 4 is a partial top view of the power module according to an embodiment of the disclosure, wherein the housing cover part 200 is omitted. Fig. 5 is a cross-sectional view taken along the line A-A in Fig. 1. Fig. 6 is a schematic diagram of a power module P according to another embodiment of the disclosure. As shown in Fig. 4, the housing box part 100 includes a box combination structure 110. In detail, when the housing cover part 200 is installed on the housing box part 100, the sensing component 400 may be inserted into the box combination structure 110, so that the sensing component 400 can be detachably installed on the box combination structure 110. Furthermore, the restriction of the slot wall of the box combination structure 110 can provide a resistance between the box combination structure 110 and the sensing component 400 to achieve a tight fit. The tight fit can restrict the sensing component 400 to leave the housing cover part 200 merely along an inserting direction. Additionally, the inserting direction is a third direction along the Y-axis, and the third direction is perpendicular to the first axial direction and the second axial direction. In some embodiments, the box combination structure 110 may be a fixing slot, but it is not limited thereto. The mechanism of the box combination structure 110 configured to dispose the sensing component 400 may be designed according to the appearance of the sensing component 400, without restricting any specific shape. In some embodiments, the box combination structure 110 and the sensing component 400 are detachably latched, buckled, and/or combined with each other to achieve a tight fit, so that the sensing component 400 can be tight fitted with the housing box part 100, and the sensing component 400 can be detached from the housing box part 100 or combined to the housing box part 100 again in any time.

As shown in Fig. 5, in some embodiments, the sensing component 400 may be coupled to the metal terminal 500 in indirect contact to detect the value of the current flowing through the metal terminal 500. For example, the sensing component 400 may be spaced away from the metal terminal 500 with a gap G to detect the value of the current of the metal terminal 500. In some embodiments, the gap G may be greater than 0.5 mm to avoid the circuit from damaging, but it is not limited thereto.

As shown in Fig. 6, in some embodiments, the sensing component 400 may be coupled to the metal terminal 500 in direct contact to detect the value of the voltage of the metal terminal 500. Furthermore, the sensing component 400 may be coupled to the metal terminal 500 in direct contact or indirect contact to detect the value of the voltage, the value of the current, the humidity, the temperature, the light perception, the pressure, and/or the magnetic field of the metal terminal 500 or the combination thereof, so that parameters of the power component 300 can be measured, but it is not limited thereto.

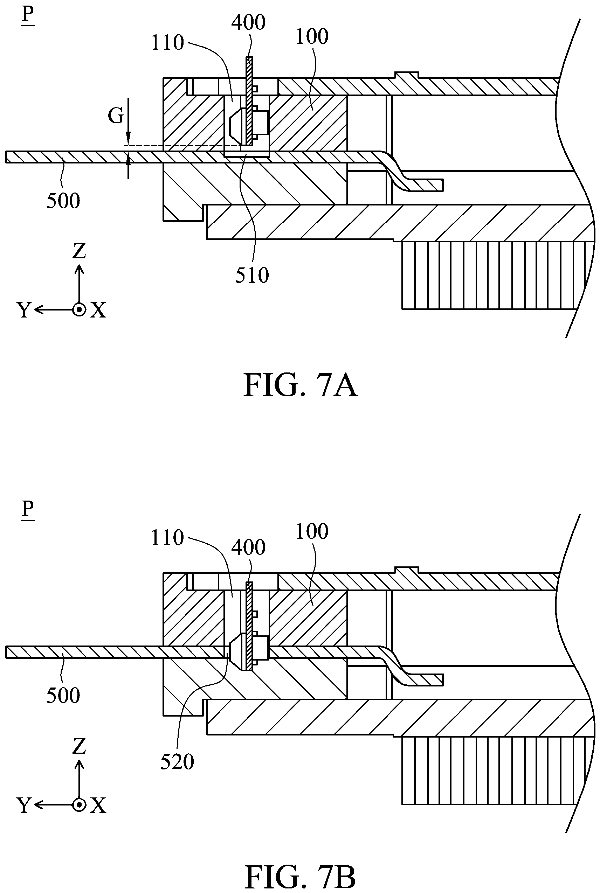

Fig. 7A is a schematic diagram of a power module P according to another embodiment of the disclosure, and Fig. 7B is a schematic diagram of a power module P according to still another embodiment of the disclosure. As shown in Fig. 7A, in some embodiments, the box combination structure 110 includes a metal recess 510 on the metal terminal 500. When the housing cover part 200 is installed on the housing box part 100, the sensing component 400 is inserted into the box combination structure 110 and the metal recess 510 to achieve the coupling between the sensing component 400 and the metal terminal 500 in direct contact or indirect contact. The slot wall of the box combination structure 110 and/or the slot wall of the metal recess 510 may restrict the sensing component 400 to leave the housing box part 100 merely along an inserting direction. The sensing component 400 can be tight fitted with the housing box part 100. In some embodiments, the depth of the metal recess 510 is less than 0.5 mm, but it is not limited thereto. As shown in Fig. 7B, in some embodiments, the metal terminal 500 may include a hollow hole 520. When the housing cover part 200 is installed on the housing box part 100, the sensing component 400 can pass through the hollow hole 520 and can be inserted into the box combination structure 110 to achieve the coupling between the sensing component 400 and the metal terminal 500 in direct contact or indirect contact. The slot wall of the box combination structure 110 and/or the slot wall of the hollow hole 520 may restrict the sensing component 400 to leave the housing box part 100 merely along an inserting direction. The sensing component 400 can be tight fitted with the housing box part 100.

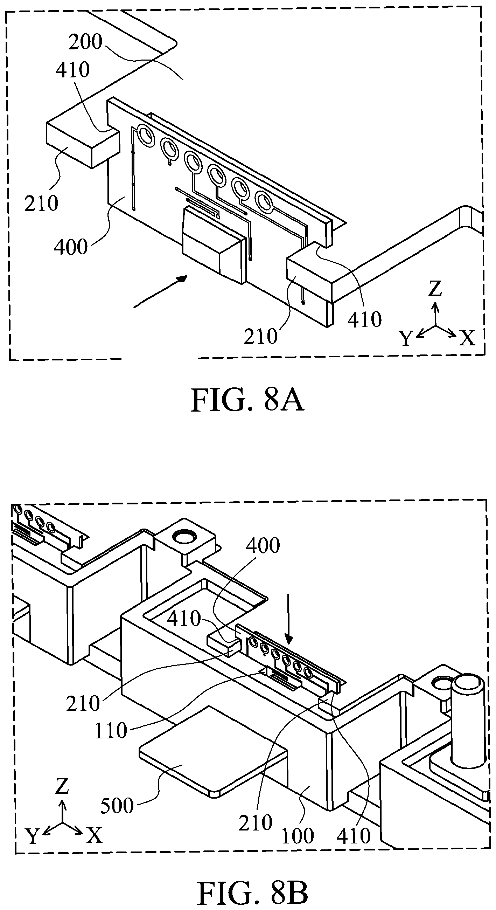

Fig. 8A and Fig. 8B are schematic diagrams of the assembling steps of the power module according to an embodiment of the disclosure. First, as shown in Fig. 8A, the sensing component 400 can be detachably installed to the housing cover part 200 along a direction that is perpendicular or parallel to the housing cover part 200. In particular, the component combination structure 410 of the sensing component 400 can move along the direction that is perpendicular or parallel to the housing cover part 200 to let the cover combination structure 210 and the component combination structure 410 detachably combining. A resistance is provided between the component combination structure 410 and the cover combination structure 210, so that a tight fit can be achieved. The tight fit can restrict the movement of the sensing component 400 in a first axial direction and a second axial direction. The first axial direction and the second axial direction is perpendicular or parallel to the housing cover part 200. More in particular, the first axial direction is a first direction along the X-axis and parallel to the housing cover part 200, and the second axial direction is a second direction along the Z-axis and perpendicular to the housing cover part 200.

Subsequently, as shown in Fig. 8B, when the housing cover part 200 is installed on the housing box part 100, the sensing component 400 can be inserted to the housing box part 100. In particular, when the housing cover part 200 is installed on the housing box part 100, the sensing component 400 can be inserted into the box combination structure 110 of the housing box part 100, so that the sensing component 400 can be detachably installed on the housing box part 100. In detail, at this time, the sensing component 400 can be detachably installed on the housing box part 100 and the housing cover part 200 to achieve a tight fit.

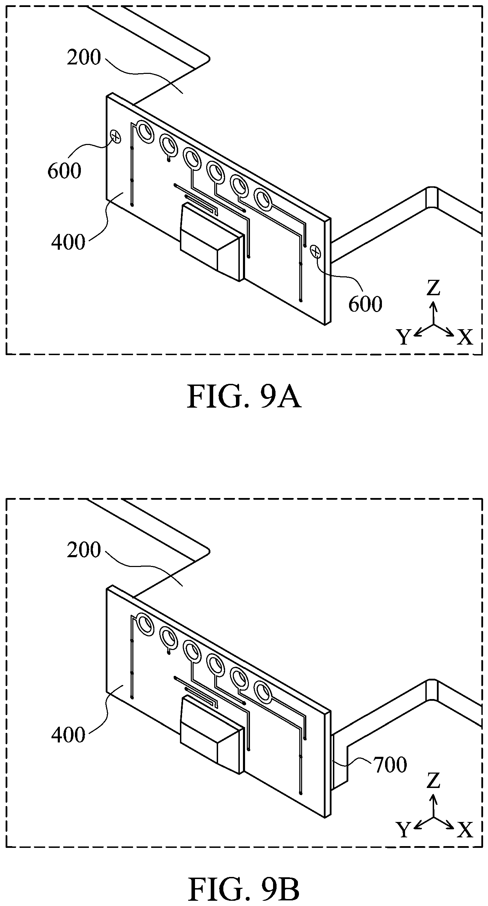

Fig. 9A is a schematic diagram of the housing cover part 200 and the sensing component 400 according to another embodiment of the disclosure, and Fig. 9B is a schematic diagram of the housing cover part 200 and the sensing component 400 according to still another embodiment of the disclosure. As shown in Fig. 9A, in some embodiments, the sensing component 400 may be installed on the housing cover part 200 by locking. In particular, the cover combination structure 210 may be a screw boss (not shown), and the component combination structure 410 may be an assembling through hole (not shown). In detail, the power module may further include a screw 600 configured to pass through the assembly through hole and lock on the screw boss to achieve a tight fit, and the sensing component 400 can be detached from the housing cover part 200 or combined to the housing cover part 200 again in any time.

As shown in Fig. 9B, in some embodiments, the sensing component 400 may be installed on the housing cover part 200 by adhering. In particular, at least one of the cover combination structure 210 and the component combination structure 410 may include an glue layer 700 configured to adhere the cover combination structure 210 and the component combination structure 310 to achieve a tight fit, and the sensing component 400 can be detached from the housing cover part 200 or combined to the housing cover part 200 again in any time. In some embodiments, the glue layer 700 may be an adhesive agent, such as a UV curable adhesive, a conductive adhesive, a hot melt adhesive, an acrylic adhesive, an epoxy adhesive, and an adhesive film, but it is not limited thereto.

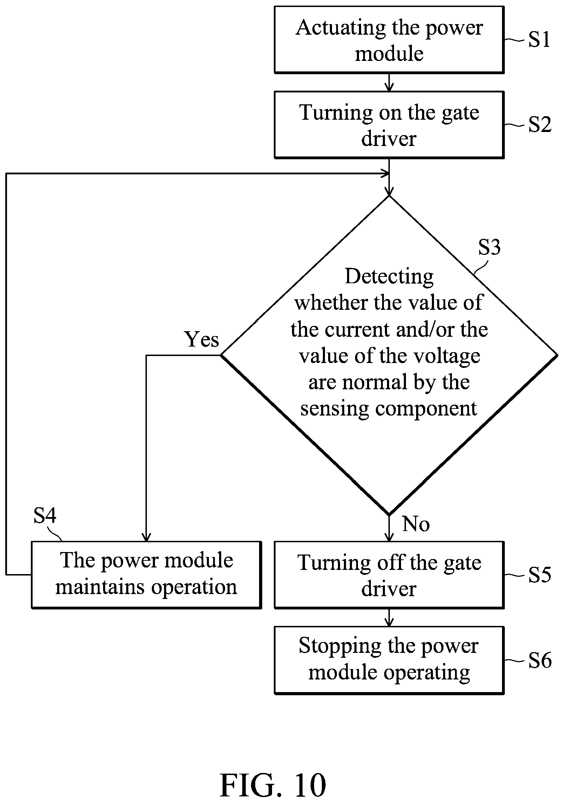

Fig. 10 is a flow chart diagram of the operation steps of the power module P according to an embodiment of the disclosure. In some embodiments, as shown in Fig. 10 the power module in the embodiment of the disclosure can be coupled to a gate driver (not shown). In the step S1, the power module can be actuated. In some embodiments, the power module can be coupled to other apparatuses and/or devices. When the apparatuses and/or devices are turned on, they can actuate the power module.

In the step S2, the gate driver can be turned on. In some embodiments, the gate driver can be disposed in the power module or out of the power module maintain the operation of the power module or stop the power module operating. Subsequently, in step S3, the sensing component can detect the value of the current and/or the value of the voltage of the metal terminal, and determine that whether the value of the current and/or the value of the voltage of the metal terminal are in a normal range.

If the value of the current and/or the value of the voltage of the metal terminal are in the normal range, the step S4 can be followed. In step S4, the gate drive is not turned off, the power module can maintain its operation, and the operation steps can return to the step S3 to detect the value of the current and/or the value of the voltage of the metal terminal by the sensing component and continuously determine that whether the value of the current and/or the value of the voltage of the metal terminal are in the normal range. If the value of the current and/or the value of the voltage of the metal terminal are not in the normal range, the step S5 and the step S6 can be followed, the gate driver can be turned off to stop the power module operating, and the short circuit or the overload of the current caused by the power module can be prevented.

In summary, according to the power module with detachable function disclosed by the disclosure, a combination method with detachable function can be provided. The sensing component can be detachably installed on the power module by tight fitting, locking, and/or attaching. When the sensing component is abnormal or another sensing component having different measure range, having different sensitiveness, or measuring the voltage is required to use, the sensing component can be easily replaced. Moreover, for prevent the power module from the short circuit or the overload of the current, the sensing component can stop the power module from operating according to the detected value of the current and/or the voltage.

## Claims

1. A power module (P) with detachable function, comprising:
a housing box part (100);
a housing cover part (200), installed on the housing box part and comprising a cover combination structure (210);
a power component (300) , mounted in the housing box part; and
a sensing component (400), used to measure parameters of the power component and comprising a component combination structure (410), wherein the component combination structure is detachably combined with the cover combination structure, so that the sensing component is detachably installed on the housing cover part.

2. The power module as claimed in claim 1, further comprising:
a metal terminal (500), disposed on the housing box part and coupled to the power component, wherein the sensing component is coupled to the metal terminal in direct contact or indirect contact.

3. The power module as claimed in claim 2, wherein the sensing component measures a value of a current of the metal terminal in indirect contact or measures a value of a voltage of the metal terminal in direct contact.

4. The power module as claimed in claim 2 or 3, wherein the cover combination structure (210) is a positioning protrusion, and the component combination structure (410) is a positioning recess, wherein dimensions of the positioning protrusion are greater than dimensions of the positioning recess, so that the positioning protrusion is tight fitted with the positioning recess.

5. The power module as claimed in claim 4, wherein a design in which the positioning protrusion and the positioning recess are tight fitted restricts movement of the sensing component in a first axial direction and a second axial direction, wherein the first axial direction is perpendicular to the second axial direction.

6. The power module as claimed in any one of claims 2 to 5, wherein the cover combination structure is a screw boss, and the component combination structure is an assembly through hole, wherein the power module further comprises a screw (600) configured to pass through the assembly through hole and lock on the screw boss.

7. The power module as claimed in any one of claims 2 to 6, wherein the housing box part comprises a box combination structure, and when the housing cover part is installed on the housing box part, the sensing component is inserted into the box combination structure, wherein the box combination structure (110) is a fixing slot, and when the housing cover part is installed on the housing box part, the sensing component is inserted into the fixing slot, and the sensing component can merely leave the housing cover part along an inserting direction due to a restriction of a slot wall of the fixing slot.

8. The power module as claimed in claim 7, wherein the box combination structure comprises a metal recess (510) on the metal terminal, and when the housing cover part is installed on the housing box part, the sensing component is inserted into the box combination structure and the metal recess, or
the metal terminal comprises a hollow hole, and when the housing cover part is installed on the housing box part, the sensing component passes through the hollow hole (520) and is inserted into the box combination structure.

9. The power module as claimed in any one of claims 1 to 8, wherein at least one of the cover combination structure and the component combination structure has a glue layer (700) configured to adhere the cover combination structure and the component combination structure.
